# EUROPÄISCHE PATENTANMELDUNG

(11) **EP 3 886 160 A1**
(43) Veröffentlichungstag der Anmeldung: **29.09.2021**
(21) Anmeldenummer: 21164760.7
(22) Anmeldetag: 25.03.2021
(51) Int. Cl.: H01L 23/66, H05K 1/02, H01L 23/538

(54) **HOCHFREQUENZANORDNUNG MIT ZWEI MITEINANDER VERBUNDENEN HOCHFREQUENZKOMPONENTEN**

(30) Priorität: 26.03.2020 DE 102020203971
(71) Anmelder: FRAUNHOFER-GESELLSCHAFT zur Förderung der angewandten Forschung e.V., 80686 München (DE)
(72) Erfinder: Ramm, Peter, 80686 München (DE); Weber, Josef, 80686 München (DE)
(74) Vertreter: Schlenker, Julian

(57) **Zusammenfassung**

Ausführungsbeispiele der vorliegenden Erfindung schaffen eine Hochfrequenzanordnung. Die Hochfrequenzanordnung umfasst eine erste Hochfrequenzkomponente, eine zweite Hochfrequenzkomponente und ein Verdrahtungssubstrat mit einer in dem Verdrahtungssubstrat gebildeten koaxialen Hochfrequenzleitung, wobei die erste Hochfrequenzkomponente und die zweite Hochfrequenzkomponente über die koaxiale Hochfrequenzleitung verbunden sind.

## Beschreibung

Ausführungsbeispiele der vorliegenden Erfindung beziehen sich auf eine Hochfrequenzanordnung und, im speziellen, auf eine Hochfrequenzanordnung mit zwei miteinander verbundenen Hochfrequenzkomponenten. Weitere Ausführungsbeispiele beziehen sich auf ein Verfahren zur Herstellung einer Hochfrequenzanordnung.

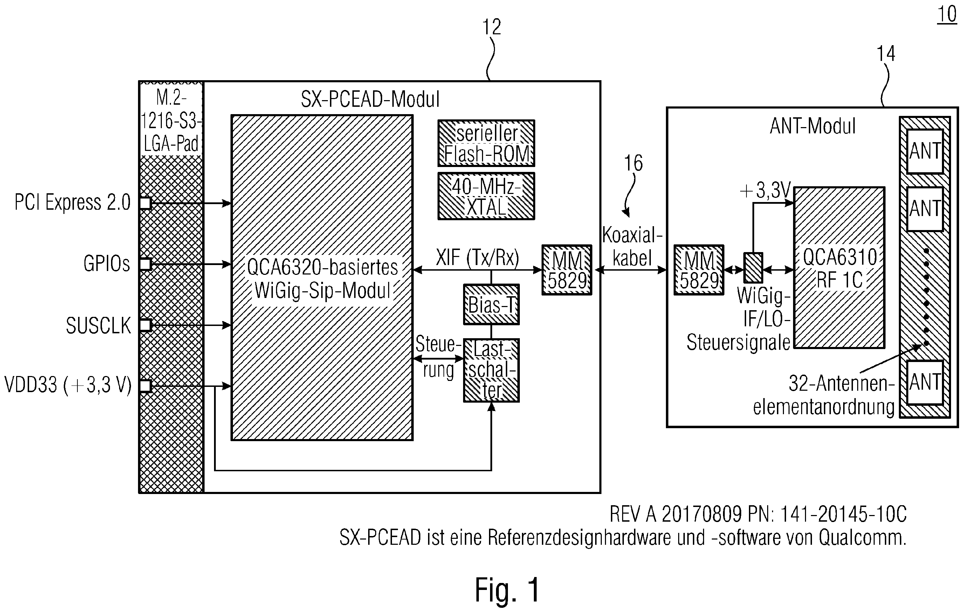

Fig. 1 zeigt ein schematisches Blockschaltbild einer herkömmlichen Hochfrequenzanordnung mit zwei miteinander verbundenen Hochfrequenzkomponenten (Basisbandplatine und Antennenplatine) 12 und 14 gem. [1].

Wie in Fig. 1 zu erkennen ist, wird herkömmlicherweise beim Aufbau von Systemen der mobilen Kommunikation die elektrische Verbindung einer Hochfrequenzkomponente 12, wie z.B. einer Basisbandplatine (engl. Baseband Board), z.B. einem Basisbandprozessor zusammen mit weiteren Schaltungen auf einem PCB (PCB = Printed Circuit Board, dt. Leiterplatte), mit mindestens einer weiteren elektronischen Komponente 14, wie z.B. einer Antennenplatine (engl. Antenna Board; typisch Antennen, RFIC, etc.), über Koaxialkabel 16 und Koaxialanschlüsse als Hochfrequenzverbindung (typisch 60GHz-fähig) realisiert. Die Fig. 2 und 3 zeigen hierbei Koaxialanschlüsse 18 und 20 einer Basisbandplatine 12, ausgeführt als Basisband System-on-Package, und einer Antennenplatine 14 gem. [1].

Ein solche herkömmliche Hochfrequenzanordnung ist jedoch in der Produktion mit vergleichsweise hohen Herstellungskosten verbunden. Die Kosten für die eingesetzten Koaxialelemente - Buchsen und Kabel - sowie die Anschlüsse an die jeweiligen Metallisierungsebenen der elektronischen Komponenten sind sehr erheblich im Vergleich zu den herkömmlicherweise eingesetzten modernen hochintegrierten sog. Systems-in-Package (dt. verkapselte Systeme) Technologien für die Herstellung der zu verbindenden elektronischen Komponenten.

Der vorliegenden Erfindung liegt daher die Aufgabe zugrunde, ein Konzept zu schaffen, welches eine kostengünstigere Verbindung von Hochfrequenzkomponenten ermöglicht.

Diese Aufgabe wird durch die unabhängigen Patentansprüche gelöst.

Vorteilhafte Weiterbildungen finden sich in den abhängigen Patentansprüchen.

Ausführungsbeispiele schaffen eine Hochfrequenzanordnung. Die Hochfrequenzanordnung umfasst eine erste Hochfrequenzkomponente, eine zweite Hochfrequenzkomponente, und ein Verdrahtungssubstrat mit einer in dem Verdrahtungssubstrat gebildeten koaxialen Hochfrequenzleitung, wobei die erste Hochfrequenzkomponente und die zweite Hochfrequenzkomponente über die koaxiale Hochfrequenzleitung verbunden sind.

Bei Ausführungsbeispielen ist die erste Hochfrequenzkomponente eine Basisbandplatine.

Bei Ausführungsbeispielen ist die zweite Hochfrequenzkomponente eine Antennenplatine.

Bei Ausführungsbeispielen umfasst die koaxiale Hochfrequenzleitung zumindest einen Innenleiter und zumindest einen Außenleiter zur Hochfrequenzabschirmung des zumindest einen Innenleiters, wobei der zumindest eine Außenleiter den zumindest einen Innenleiter umgibt, wobei der zumindest eine Außenleiter und der zumindest eine Innenleiter voneinander isoliert sind.

Bei Ausführungsbeispielen ist zumindest ein Hochfrequenzsignal-Anschluss der ersten Hochfrequenzkomponente über den zumindest einen Innenleiter mit zumindest einem Hochfrequenzsignal-Anschluss der zweiten Hochfrequenzkomponente verbunden, wobei zumindest ein Hochfrequenzabschirm-Anschluss der ersten Hochfrequenzkomponente über den zumindest einen Außenleiter mit zumindest einem Hochfrequenzabschirm-Anschluss der zweiten Hochfrequenzkomponente verbunden ist.

Bei Ausführungsbeispielen verläuft der zumindest eine Innenleiter lateral in dem Verdrahtungssubstrat, so dass der zumindest eine Innenleiter parallel zu einer der ersten Hochfrequenzkomponente und der zweiten Hochfrequenzkomponente benachbarten Oberfläche des Verdrahtungssubstrats angeordnet ist, wobei der zumindest eine Innenleiter über zumindest zwei voneinander beabstandete und vertikal in dem Verdrahtungssubstrat verlaufende Verbindungsleiter an die Oberfläche des Verdrahtungssubstrats geführt ist, wobei ein erster Verbindungsleiter der zumindest zwei Verbindungsleiter mit dem zumindest einen Hochfrequenzsignal-Anschluss der ersten Hochfrequenzkomponente verbunden ist, wobei ein zweiter Verbindungsleiter der zumindest zwei Verbindungsleiter mit dem zumindest einen Hochfrequenzsignal-Anschluss der zweiten Hochfrequenzkomponente verbunden ist.

Bei Ausführungsbeispielen ist der den zumindest einen Innenleiter umgebende zumindest eine Außenleiter in Bereichen der zumindest zwei Verbindungsleiter geöffnet.

Weitere Ausführungsbeispiele schaffen ein Mobilfunkgerät mit einer hierin bzw. oben beschriebenen Hochfrequenzanordnung.

Weitere Ausführungsbeispiele schaffen ein Verfahren zur Herstellung einer Hochfrequenzanordnung. Das Verfahren umfasst ein Bereitstellen einer ersten Hochfrequenzkomponente. Ferner umfasst das Verfahren ein Bereitstellen einer zweiten Hochfrequenzkomponente. Ferner umfasst das Verfahren ein Bereitstellen eines Verdrahtungssubstrats mit einer in dem Verdrahtungssubstrat gebildeten koaxialen Hochfrequenzleitung. Ferner umfasst das Verfahren ein Verbinden der ersten Hochfrequenzkomponente und der zweiten Hochfrequenzkomponente über das Verdrahtungssubstrat.

Bei Ausführungsbeispielen ist die erste Hochfrequenzkomponente eine Basisbandplatine.

Bei Ausführungsbeispielen ist die zweite Hochfrequenzkomponente eine Antennenplatine.

Bei Ausführungsbeispielen weist die koaxiale Hochfrequenzleitung zumindest einen Innenleiter und zumindest einen Außenleiter zur Hochfrequenzabschirmung des zumindest einen Innenleiters auf, wobei der zumindest eine Außenleiter den zumindest einen Innenleiter umgibt, wobei der zumindest eine Außenleiter und der zumindest eine Innenleiter voneinander isoliert sind.

Bei Ausführungsbeispielen wird bei dem Verbinden der ersten Hochfrequenzkomponente und der zweiten Hochfrequenzkomponente über das Verdrahtungssubstrat zumindest ein Hochfrequenzsignal-Anschluss der ersten Hochfrequenzkomponente über den zumindest einen Innenleiter mit zumindest einem Hochfrequenzsignal-Anschluss der zweiten Hochfrequenzkomponente verbunden, wobei bei dem Verbinden der ersten Hochfrequenzkomponente und der zweiten Hochfrequenzkomponente über das Verdrahtungssubstrat zumindest ein Hochfrequenzabschirm-Anschluss der ersten Hochfrequenzkomponente über den zumindest einen Außenleiter mit zumindest einem Hochfrequenzabschirm-Anschluss der zweiten Hochfrequenzkomponente verbunden wird.

Bei Ausführungsbeispielen verläuft der zumindest eine Innenleiter lateral in dem Verdrahtungssubstrat, so dass der zumindest eine Innenleiter parallel zu einer der ersten Hochfrequenzkomponente und der zweiten Hochfrequenzkomponente benachbarten Oberfläche des Verdrahtungssubstrats angeordnet ist, wobei der zumindest eine Innenleiter über zumindest zwei voneinander beabstandete und vertikal in dem Verdrahtungssubstrat verlaufende Verbindungsleiter an die Oberfläche des Verdrahtungssubstrats geführt ist, wobei bei dem Verbinden der ersten Hochfrequenzkomponente und der zweiten Hochfrequenzkomponente über das Verdrahtungssubstrat ein erster Verbindungsleiter der zumindest zwei Verbindungsleiter mit dem zumindest einen Hochfrequenzsignal-Anschluss der ersten Hochfrequenzkomponente verbunden wird, wobei bei dem Verbinden der ersten Hochfrequenzkomponente und der zweiten Hochfrequenzkomponente über das Verdrahtungssubstrat ein zweiter Verbindungsleiter der zumindest zwei Verbindungsleiter mit dem zumindest einen Hochfrequenzsignal-Anschluss der zweiten Hochfrequenzkomponente verbunden wird.

Bei Ausführungsbeispielen weist das Bereitstellen des Verdrahtungssubstrats ein Bereitstellen eines Substrats und Bilden der koaxialen Hochfrequenzleitung in dem Substrat auf.

Weitere Ausführungsbeispiele schaffen eine Vorrichtung. Die Vorrichtung umfasst mindestens zwei elektrische Hochfrequenzkomponenten mit jeweils mindestens einem Anschlusspad für Hochfrequenzsignale und jeweils mindestens einem Anschlusspad für mindestens einen Außenleiter zur Hochfrequenzabschirmung. Ferner umfasst die Vorrichtung ein Verdrahtungssubstrat, wobei das Verdrahtungssubstrat eine geschirmte Hochfrequenz-Transmissionsleitungs-Struktur aufweist, die mindestens einen Innenleiter, mindestens einem Außenleiter, eine Isolation um den mindestens einen Innenleiter, sowie eine Isolation um den mindestens einen Außenleiter aufweist. Ferner umfasst die Vorrichtung mindestens eine elektrisch leitende Verbindung zwischen dem mindestens einen Anschlusspad der ersten Hochfrequenzkomponente und dem mindestens einen Innenleiter der geschirmten Hochfrequenz-Transmissionsleitungs-Struktur in dem Verdrahtungssubstrat. Ferner umfasst die Vorrichtung mindestens eine elektrisch leitende Verbindung zwischen dem mindestens einen Anschlusspad der zweiten Hochfrequenzkomponente und dem mindestens einen Außenleiter der geschirmten Hochfrequenz-Transmissionsleitungs-Struktur in dem Verdrahtungssubstrat.

Weitere Ausführungsbeispiele schaffen ein Verfahren zum Verbinden von mindestens zwei elektrischen Hochfrequenzkomponenten. Das Verfahren umfasst einen Schritt des Bereitstellens von mindestens zwei elektrischen Hochfrequenzkomponenten mit jeweils mindestens einem Anschlusspad für Hochfrequenzsignale und jeweils mindestens einem Anschlusspad für mindestens einen Außenleiter zur Hochfrequenzabschirmung. Ferner umfasst das Verfahren einen Schritt des Bereitstellens eines Verdrahtungssubstrates. Ferner umfasst das Verfahren einen Schritt des Erzeugens einer geschirmten Hochfrequenz-Transmissionsleitungs-Struktur bestehend aus mindestens einem Innenleiter, mindestens einem Außenleiter, Isolation um den mindestens einen Innenleiter, sowie Isolation um den mindestens einen Außenleiter in dem Verdrahtungssubstrat. Ferner umfasst das Verfahren einen Schritt des Erzeugens mindestens einer elektrisch leitenden Verbindung zwischen dem mindestens einen Anschlusspad der ersten Hochfrequenzkomponente und dem mindestens einen Innenleiter der geschirmten Hochfrequenz-Transmissionsleitungs-Struktur in dem Verdrahtungssubstrat. Ferner umfasst das Verfahren einen Schritt des Erzeugens mindestens einer elektrisch leitenden Verbindung zwischen dem mindestens einen Anschlusspad der zweiten Hochfrequenzkomponente und dem mindestens einen Außenleiter der geschirmten Hochfrequenz-Transmissionsleitungs-Struktur in dem Verdrahtungssubstrat.

Ausführungsbeispiele der vorliegenden Erfindung schaffen Hochfrequenz-elektrische Verbindung von Komponenten mittels Verdrahtungssubstrat mit integrierter Transmissionsleitung.

Ausführungsbeispiele der vorliegenden Erfindung schaffen ein Verfahren zur Herstellung von elektronischen Hochfrequenzsystemen, und insbesondere von hochintegrierten sog. Systems-in-Package (dt. verkapselte Systeme) für den Einsatz in der mobilen Kommunikation.

Ausführungsbeispiele der vorliegenden Erfindung realisieren die elektrische Verbindung von mindestens zwei elektrischen Hochfrequenzkomponenten über ein spezifisches Verdrahtungssubstrat mit integrierter Hochfrequenz-Transmissionsleitungsstruktur und geeigneten Anschlussverbindungen zu den Metallisierungsebenen der Hochfrequenzkomponenten.

Ausführungsbeispiele der vorliegenden Erfindung werden bezugnehmend auf die beiliegenden Figuren näher beschrieben. Es zeigen:
- Fig. 1: ein schematisches Blockschaltbild einer herkömmlichen Hochfrequenzanordnung mit zwei miteinander verbundenen Hochfrequenzkomponenten (Basisbandplatine und Antennenplatine) gem. [1].

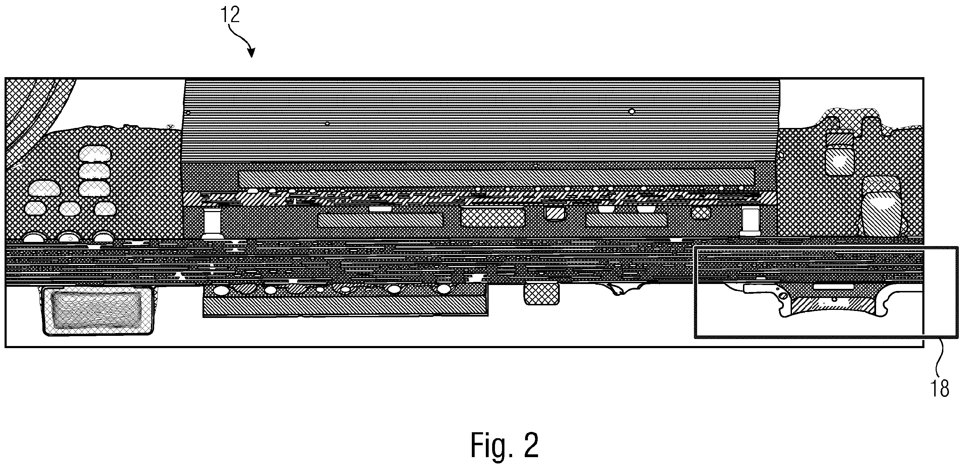

- Fig. 2: eine schematische Querschnittsansicht einer Basisbandplatine (Basisband System-on-Package) mit einem koaxialen Anschlussbuchse gem. [1],

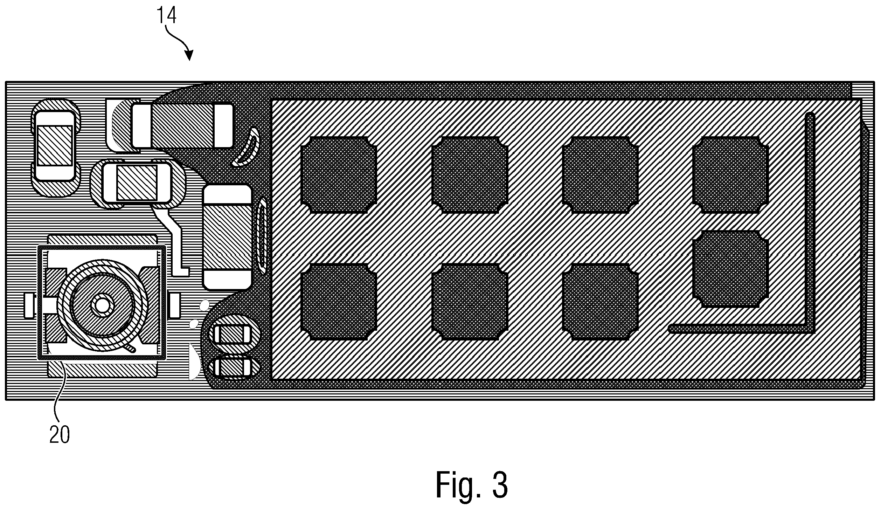

- Fig. 3: eine schematische Ansicht einer Antennenplatine mit einer koaxialen Anschlussbuchse gem. [1],

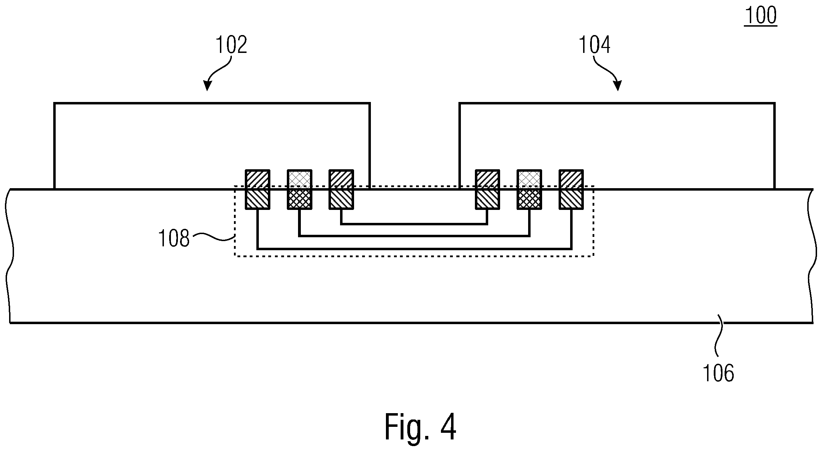

- Fig. 4: eine schematische Querschnittsansicht einer Hochfrequenzanordnung, gemäß einem Ausführungsbeispiel der vorliegenden Erfindung,

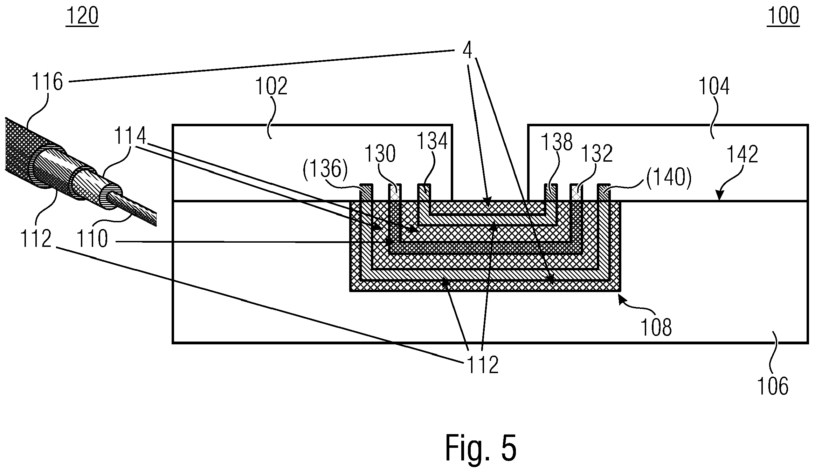

- Fig. 5: eine schematische Querschnittsansicht einer Hochfrequenzanordnung, gemäß einem weiteren Ausführungsbeispiel der vorliegenden Erfindung,

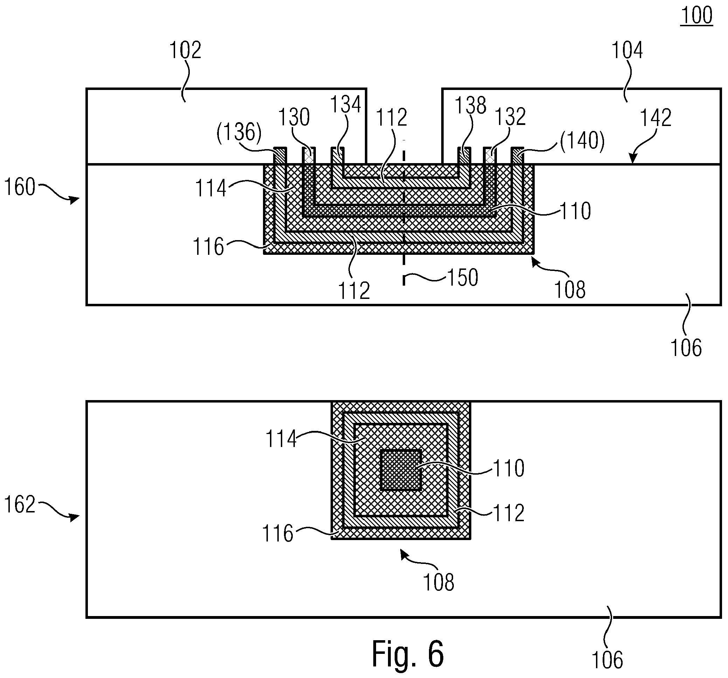

- Fig. 6: eine schematische Querschnittsansicht der Hochfrequenzanordnung aus Fig. 5 sowie eine schematische Querschnittsansicht des Verdrahtungssubstrats entlang einer Schnittebene, die senkrecht durch die koaxiale Hochfrequenzleitung im Bereich zwischen den zwei Hochfrequenzkomponenten verläuft, gemäß einem Ausführungsbeispiel,

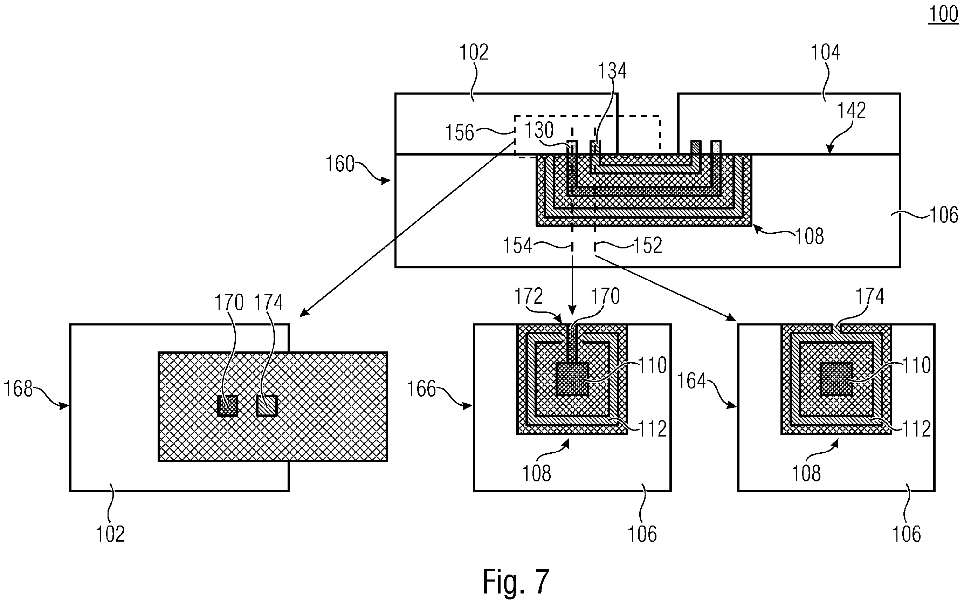

- Fig. 7: eine schematische Querschnittsansicht der Hochfrequenzanordnung aus Fig. 5, eine schematische Querschnittsansicht des Verdrahtungssubstrats entlang einer Schnittebene, die senkrecht durch die koaxiale Hochfrequenzleitung im Bereich des Hochfrequenzabschirm-Anschlusses der ersten Hochfrequenzkomponente verläuft, eine schematische Querschnittsansicht des Verdrahtungssubstrats entlang einer Schnittebene, die senkrecht durch die koaxiale Hochfrequenzleitung im Bereich des Hochfrequenzsignal-Anschlusses der ersten Hochfrequenzkomponente verläuft, sowie eine Draufsicht auf das Verdrahtungssubstrat im Bereich der ersten Hochfrequenzkomponente,

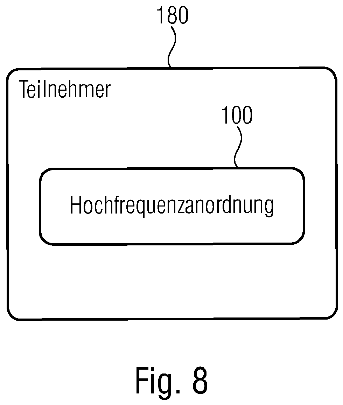

- Fig. 8: ein schematisches Blockschaltbild eines Teilnehmers eines Mobilfunksystems mit einer Hochfrequenzanordnung, gemäß einem Ausführungsbeispiel der vorliegenden Erfindung,

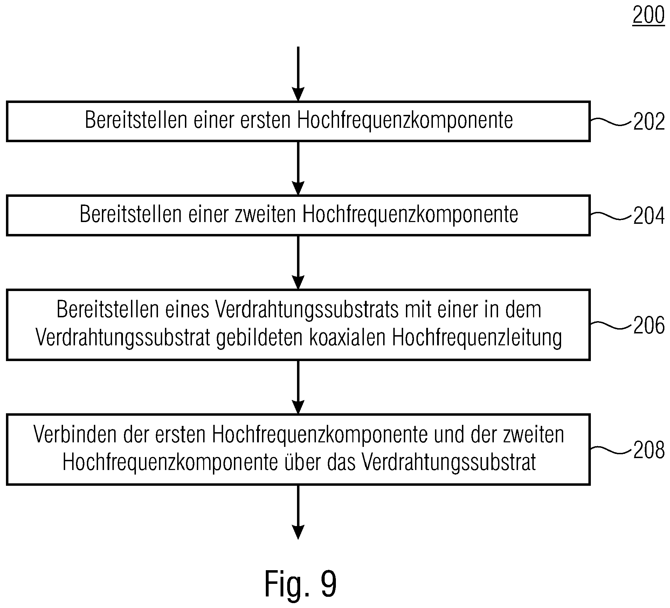

- Fig. 9: ein Flussdiagramm eines Verfahrens zur Herstellung einer Hochfrequenzanordnung, gemäß einem Ausführungsbeispiel der vorliegenden Erfindung, und

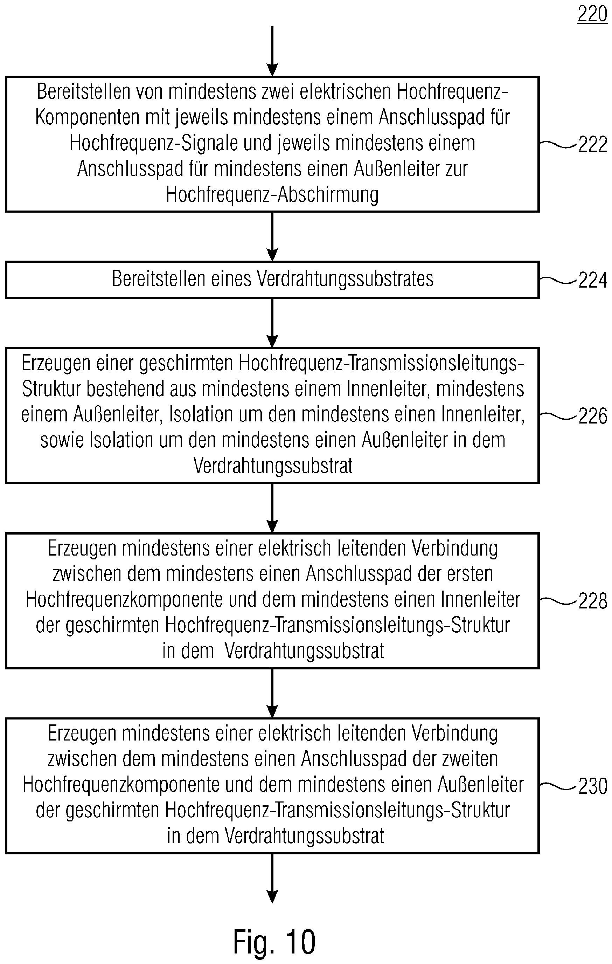

- Fig. 10: ein Flussdiagramm eines Verfahrens zum Verbinden von mindestens zwei elektrischen Hochfrequenzkomponenten, gemäß einem Ausführungsbeispiel.

In der nachfolgenden Beschreibung der Ausführungsbeispiele der vorliegenden Erfindung werden in den Figuren gleiche oder gleichwirkende Elemente mit dem gleichen Bezugszeichen versehen, so dass deren Beschreibung untereinander austauschbar ist.

Fig. 4 zeigt eine schematische Querschnittsansicht einer Hochfrequenzanordnung 100, gemäß einem Ausführungsbeispiel der vorliegenden Erfindung. Die Hochfrequenzanordnung 100 umfasst eine erste Hochfrequenzkomponente 102, eine zweite Hochfrequenzkomponente 104 und ein Verdrahtungssubstrat 106 mit einer in dem Verdrahtungssubstrat 106 gebildeten koaxialen Hochfrequenzleitung 108, wobei die erste Hochfrequenzkomponente 102 und die zweite Hochfrequenzkomponente 104 über die koaxiale Hochfrequenzleitung 108 verbunden sind.

Fig. 5 zeigt eine schematische Querschnittsansicht einer Hochfrequenzanordnung 100, gemäß einem weiteren Ausführungsbeispiel der vorliegenden Erfindung. Mit anderen Worten, Fig. 5 zeigte eine Realisierungsmöglichkeit der in dem Verdrahtungssubstrat 106 geformten koaxialen Hochfrequenzleitung 108.

Wie auch bei einem herkömmlichen Koaxialkabel 60, welches in Fig. 4 beispielhaft für Vergleichszwecke gezeigt ist, kann bei Ausführungsbeispielen die koaxiale Hochfrequenzleitung 108 zumindest einen Innenleiter 110 und zumindest einen Außenleiter 112 zur Abschirmung (z.B. Hochfrequenzabschirmung) des zumindest einen Innenleiters 110 aufweisen, wobei der zumindest eine Außenleiter 112 den zumindest einen Innenleiter 110 umgibt, und wobei der zumindest eine Außenleiter 112 und der zumindest eine Innenleiter 112 voneinander isoliert sind, z.B. mittels einer Isolation 114, wie z.B. einem Dielektrikum (z.B. SiO2). Ferner kann auch der zumindest eine Außenleiter 112 isoliert sein, z.B. mittels einer Isolation 116, wie z.B. einem Dielektrikum (z.B. SiO2).

Bei Ausführungsbeispielen kann der zumindest eine Innenleiter 110 aus einem elektrisch leitfähigen Material gefertigt sein, wie z.B. Kupfer, Silber oder Gold.

Bei Ausführungsbeispielen kann der zumindest eine Außenleiter 112 aus einem elektrisch leitfähigen Material gefertigt sein, wie z.B. Kupfer, Silber oder Gold. Bevorzugt kann der zumindest eine Außenleiter 112 ein Referenzpotential, wie z.B. Masse führen.

Bei Ausführungsbeispielen kann zumindest ein Hochfrequenzsignal-Anschluss 130 der ersten Hochfrequenzkomponente 102 über den zumindest einen Innenleiter 110 mit zumindest einem Hochfrequenzsignal-Anschluss 132 der zweiten Hochfrequenzkomponente 104 verbunden sein, wobei zumindest ein Hochfrequenzabschirm-Anschluss 134 (und optional 136) der ersten Hochfrequenzkomponente 102 über den zumindest einen Außenleiter 112 mit zumindest einem Hochfrequenzabschirm-Anschluss 138 (und optional 140) der zweiten Hochfrequenzkomponente 104 verbunden ist.

Bei Ausführungsbeispielen kann der zumindest eine Innenleiter 110 parallel zu einer der ersten Hochfrequenzkomponente 102 und/oder der zweiten Hochfrequenzkomponente 104 benachbarten Oberfläche 142 des Verdrahtungssubstrats 106 angeordnet sein, wobei der zumindest eine Innenleiter 110 über zumindest zwei voneinander beabstandete und vertikal in dem Verdrahtungssubstrat 106 verlaufende Verbindungsleiter an die Oberfläche 142 des Verdrahtungssubstrats 106 geführt ist, wobei ein erster Verbindungsleiter der zumindest zwei Verbindungsleiter mit dem zumindest einen Hochfrequenzsignal-Anschluss 130 der ersten Hochfrequenzkomponente 102 verbunden ist, und wobei ein zweiter Verbindungsleiter der zumindest zwei Verbindungsleiter mit dem zumindest einen Hochfrequenzsignal-Anschluss 132 der zweiten Hochfrequenzkomponente 104 verbunden ist.

Bei Ausführungsbeispielen kann die erste Hochfrequenzkomponente 102 eine Basisbandplatine sein.

Bei Ausführungsbeispielen kann die zweite Hochfrequenzkomponente 104 eine Antennenplatine sein.

Mit anderen Worten, Fig. 5 zeigt ein Beispiel für eine hochfrequenz-elektrische Verbindung von zwei Komponenten 102 und 104 mittels Verdrahtungssubstrat 106 mit integrierter Transmissionsleitung 108 (im Vergleich zu einem konventionellen Koaxialkabel 120 mit Innenleiter (Seele), Isolierungen und Hochfrequenzabschirmung.

Mit anderen Worten, Fig. 5 zeigt eine schematische Ansicht einer Vorrichtung 100, gemäß einem Ausführungsbeispiel der vorliegenden Erfindung. Die Vorrichtung 100 umfasst mindestens zwei elektrische Hochfrequenzkomponenten 102 und 104 mit jeweils mindestens einem Anschlusspad 130 und 132 für Hochfrequenzsignale und jeweils mindestens einem Anschlusspad 134 (und optional 136) und 138 (und optional 140) für mindestens einen Außenleiter 112 zur Hochfrequenzabschirmung. Ferner umfasst die Vorrichtung 100 ein Verdrahtungssubstrat 106, wobei das Verdrahtungssubstrat 106 eine geschirmte Hochfrequenz-Transmissionsleitungs-Struktur 108 aufweist, die mindestens einen Innenleiter 110, mindestens einem Außenleiter 112, eine Isolation 114 um den mindestens einen Innenleiter 110, sowie eine Isolation 116 um den mindestens einen Außenleiter 112 aufweist. Ferner umfasst die Vorrichtung 100 mindestens eine elektrisch leitende Verbindung zwischen dem mindestens einen Anschlusspad 130 der ersten Hochfrequenzkomponente 102 und dem mindestens einen Innenleiter 110 der geschirmten Hochfrequenz-Transmissionsleitungs-Struktur 108 in dem Verdrahtungssubstrat 106. Ferner umfasst die Vorrichtung 100 mindestens eine elektrisch leitende Verbindung zwischen dem mindestens einen Anschlusspad 132 der zweiten Hochfrequenzkomponente 104 und dem mindestens einen Außenleiter 112 der geschirmten Hochfrequenz-Transmissionsleitungs-Struktur 108 in dem Verdrahtungssubstrat 106.

Fig. 6 zeigt eine schematische Querschnittsansicht 160 der Hochfrequenzanordnung 100 aus Fig. 5 sowie eine schematische Querschnittsansicht 162 des Verdrahtungssubstrats 106 entlang einer Schnittebene 150, die senkrecht durch die koaxiale Hochfrequenzleitung 108 im Bereich zwischen den zwei Hochfrequenzkomponenten 102 und 104 verläuft, gemäß einem Ausführungsbeispiel. Mit anderen Worten, Fig. 6 zeigt ein Ausführungsbeispiel einer Realisierungsmöglichkeit der koaxialen Hochfrequenzleitung 108.

Wie in Fig. 6 in der Querschnittsansicht 162 zu erkennen ist, kann die koaxiale Hochfrequenzleitung 108 einen Innenleiter 110 und einen Außenleiter 112 aufweisen, wobei der Außenleiter 112 den Innenleiter 110 umgibt, wobei der Außenleiter 112 und der Innenleiter 112 voneinander isoliert sind, z.B. mittels einer Isolation 114, und wobei auch der Außenleiter 112 von einer Isolation 116 umgeben ist.

Fig. 7 zeigt eine schematische Querschnittsansicht 160 der Hochfrequenzanordnung 100 aus Fig. 5, eine schematische Querschnittsansicht 164 des Verdrahtungssubstrats 106 entlang einer Schnittebene 152, die senkrecht durch die koaxiale Hochfrequenzleitung 108 im Bereich des Hochfrequenzabschirm-Anschlusses 134 der ersten Hochfrequenzkomponente 102 verläuft, eine schematische Querschnittsansicht 166 des Verdrahtungssubstrats 106 entlang einer Schnittebene 154, die senkrecht durch die koaxiale Hochfrequenzleitung 108 im Bereich des Hochfrequenzsignal-Anschlusses 130 der ersten Hochfrequenzkomponente 102 verläuft, sowie eine Draufsicht auf das Verdrahtungssubstrat im Bereich 156 der ersten Hochfrequenzkomponente 102. Mit anderen Worten, Fig. 7 zeigt ein Ausführungsbeispiel einer Realisierungsmöglichkeit der Anschlüsse.

Wie in Fig. 7 zu erkennen ist, kann bei Ausführungsbeispielen der Innenleiter 110 der koaxialen Hochfrequenzleitung 108 über einen vertikal in dem Verdrahtungssubstrat 106 verlaufenden Verbindungsleiter 170 (siehe Querschnittansicht 166) an eine Oberfläche 142 des Verdrahtungssubstrats 106 (vgl. Draufsicht 168) zur Verbindung mit dem Hochfrequenzsignal-Anschlusses 130 der ersten Hochfrequenzkomponente 102 geführt sein. Hierzu kann bei Ausführungsbeispielen der den Innenleiter 110 umgebende zumindest eine Außenleiter 112 der koaxialen Hochfrequenzleitung 108 im Bereich 172 des vertikal verlaufenden Verbindungsleiters 170 geöffnet sein.

Wie in Fig. 7 ferner zu erkennen ist, kann bei Ausführungsbeispielen der Außenleiter 112 der koaxialen Hochfrequenzleitung 108 über einen vertikal in dem Verdrahtungssubstrat 106 verlaufenden Verbindungsleiter 174 (siehe Querschnittsansicht 164) an eine Oberfläche 142 des Verdrahtungssubstrats 106 (siehe Draufsicht 168) zur Verbindung mit dem Abschirm-Anschlusses 134 der ersten Hochfrequenzkomponente 102 geführt sein.

Fig. 8 zeigt ein schematisches Blockschaltbild eines Teilnehmers 180 eines Mobilfunksystems (z.B. 3G, LTE oder 5G) mit einer Hochfrequenzanordnung 100, gemäß einem Ausführungsbeispiel der vorliegenden Erfindung.

Der Teilnehmer 180 kann beispielsweise ein mobiles Endgerät (engl. User Equipment) oder ein loT-Knoten (loT = Internet of Things, dt. Internet der Dinge) sein.

Fig. 9 zeigt ein Flussdiagramm eines Verfahrens 200 zur Herstellung einer Hochfrequenzanordnung 100, gemäß einem Ausführungsbeispiel der vorliegenden Erfindung. Das Verfahren 200 umfasst einen Schritt 202 des Bereitstellens einer ersten Hochfrequenzkomponente. Ferner umfasst das Verfahren einen Schritt 204 des Bereitstellens einer zweiten Hochfrequenzkomponente. Ferner umfasst das Verfahren einen Schritt 206 des Bereitstellens eines Verdrahtungssubstrats mit einer in dem Verdrahtungssubstrat gebildeten koaxialen Hochfrequenzleitung. Ferner umfasst das Verfahren einen Schritt 208 des Verbindens der ersten Hochfrequenzkomponente und der zweiten Hochfrequenzkomponente über das Verdrahtungssubstrat.

Fig. 10 zeigt ein Flussdiagramm eines Verfahrens 220 zum Verbinden von mindestens zwei elektrischen Hochfrequenzkomponenten, gemäß einem Ausführungsbeispiel. Das Verfahren 220 umfasst einen Schritt des Bereitstellens von mindestens zwei elektrischen Hochfrequenzkomponenten mit jeweils mindestens einem Anschlusspad für Hochfrequenzsignale und jeweils mindestens einem Anschlusspad für mindestens einen Außenleiter zur Hochfrequenzabschirmung. Ferner umfasst das Verfahren 220 einen Schritt 224 des Bereitstellens eines Verdrahtungssubstrates. Ferner umfasst das Verfahren 220 einen Schritt 226 des Erzeugens einer geschirmten Hochfrequenz-Transmissionsleitungs-Struktur bestehend aus mindestens einem Innenleiter, mindestens einem Außenleiter, Isolation um den mindestens einen Innenleiter, sowie Isolation um den mindestens einen Außenleiter in dem Verdrahtungssubstrat. Ferner umfasst das Verfahren 220 einen Schritt 228 des Erzeugens mindestens einer elektrisch leitenden Verbindung zwischen dem mindestens einen Anschlusspad der ersten Hochfrequenzkomponente und dem mindestens einen Innenleiter der geschirmten Hochfrequenz-Transmissionsleitungs-Struktur in dem Verdrahtungssubstrat. Ferner umfasst das Verfahren 220 einen Schritt 230 des Erzeugens mindestens einer elektrisch leitenden Verbindung zwischen dem mindestens einen Anschlusspad der zweiten Hochfrequenzkomponente und dem mindestens einen Außenleiter der geschirmten Hochfrequenz-Transmissionsleitungs-Struktur in dem Verdrahtungssubstrat.

Hierin beschriebene Ausführungsbeispiele dienen als Ersatz der konventionellen Koaxialverbindung zwischen den Komponenten, wie z.B. der Basisbandplatine (engl. baseband board) und der Antennenplatine (engl. antenna board) in der mobilen Kommunikation.

Ausführungsbeispiele der vorliegenden Erfindung überwinden die Nachteile der in Beschreibungseinleitung beschriebenen Verbindung über ein herkömmliches Koaxialkabel.

Ausführungsbeispiele der vorliegenden Erfindung ermöglichen eine hochproduktive Massenfertigung von multifunktionalen Hochfrequenzmodulen durch Bestückungstechnologien.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

### Literaturverzeichnis

[1] SystemPlus Report ©2018 by System Plus Consulting | Qualcomm WiGig60 GHz Chipset Smartphone Edition

## Patentansprüche

1. Hochfrequenzanordnung (100), mit folgenden Merkmalen:
einer ersten Hochfrequenzkomponente (102),
einer zweiten Hochfrequenzkomponente (104), und
einem Verdrahtungssubstrat (106) mit einer in dem Verdrahtungssubstrat (106) gebildeten koaxialen Hochfrequenzleitung (108),
wobei die erste Hochfrequenzkomponente (102) und die zweite Hochfrequenzkomponente (104) über die koaxiale Hochfrequenzleitung (108) verbunden sind.

2. Hochfrequenzanordnung (100) nach dem vorangehenden Anspruch,
wobei die erste Hochfrequenzkomponente (102) eine Basisbandplatine ist.

3. Hochfrequenzanordnung (100) nach einem der vorangehenden Ansprüche,
wobei die zweite Hochfrequenzkomponente (104) eine Antennenplatine ist.

4. Hochfrequenzanordnung (100) nach einem der vorangehenden Ansprüche,
wobei die koaxiale Hochfrequenzleitung (108) zumindest einen Innenleiter (110) und zumindest einen Außenleiter (112) zur Hochfrequenzabschirmung des zumindest einen Innenleiters (110) aufweist,
wobei der zumindest eine Außenleiter (112) den zumindest einen Innenleiter (110) umgibt,
wobei der zumindest eine Außenleiter (112) und der zumindest eine Innenleiter (110) voneinander isoliert sind.

5. Hochfrequenzanordnung (100) nach Anspruch 4,
wobei zumindest ein Hochfrequenzsignal-Anschluss (130) der ersten Hochfrequenzkomponente (102) über den zumindest einen Innenleiter (110) mit zumindest einem Hochfrequenzsignal-Anschluss (132) der zweiten Hochfrequenzkomponente (104) verbunden ist,
wobei zumindest ein Hochfrequenzabschirm-Anschluss (134, 136) der ersten Hochfrequenzkomponente (102) über den zumindest einen Außenleiter (112) mit zumindest einem Hochfrequenzabschirm-Anschluss (138, 140) der zweiten Hochfrequenzkomponente (104) verbunden ist.

6. Hochfrequenzanordnung (100) nach dem vorangehenden Anspruch,
wobei der zumindest eine Innenleiter (110) lateral in dem Verdrahtungssubstrat (106) verläuft, so dass der zumindest eine Innenleiter (110) parallel zu einer der ersten Hochfrequenzkomponente (102) und/oder der zweiten Hochfrequenzkomponente (104) benachbarten Oberfläche (142) des Verdrahtungssubstrats (106) angeordnet ist,
wobei der zumindest eine Innenleiter (110) über zumindest zwei voneinander beabstandete und vertikal in dem Verdrahtungssubstrat (106) verlaufende Verbindungsleiter (170) an die Oberfläche (142) des Verdrahtungssubstrats (106) geführt ist,
wobei ein erster Verbindungsleiter der zumindest zwei Verbindungsleiter (170) mit dem zumindest einen Hochfrequenzsignal-Anschluss (130) der ersten Hochfrequenzkomponente (102) verbunden ist,
wobei ein zweiter Verbindungsleiter der zumindest zwei Verbindungsleiter (170) mit dem zumindest einen Hochfrequenzsignal-Anschluss (132) der zweiten Hochfrequenzkomponente (104) verbunden ist.

7. Hochfrequenzanordnung (100) nach dem vorangehenden Anspruch,
wobei der den zumindest einen Innenleiter (110) umgebende zumindest eine Außenleiter (112) in Bereichen (172) der zumindest zwei Verbindungsleiter (170) geöffnet ist.

8. Teilnehmer eines mobilen Kommunikationssystems,
wobei der Teilnehmer eine Hochfrequenzanordnung (100) nach einem der Ansprüche 1 bis 7 aufweist.

9. Verfahren (200) zur Herstellung einer Hochfrequenzanordnung (100), wobei das Verfahren aufweist:
Bereitstellen (202) einer ersten Hochfrequenzkomponente (102),
Bereitstellen (204) einer zweiten Hochfrequenzkomponente (104),
Bereitstellen (206) eines Verdrahtungssubstrats (106) mit einer in dem Verdrahtungssubstrat (106) gebildeten koaxialen Hochfrequenzleitung (108), und
Verbinden (210) der ersten Hochfrequenzkomponente (102) und der zweiten Hochfrequenzkomponente (102) über das Verdrahtungssubstrat (106).

10. Verfahren (200) nach dem vorangehenden Anspruch,
wobei die erste Hochfrequenzkomponente (102) eine Basisbandplatine ist.

11. Verfahren (200) nach einem der vorangehenden Ansprüche,
wobei die zweite Hochfrequenzkomponente (104) eine Antennenplatine ist.

12. Verfahren (200) nach einem der vorangehenden Ansprüche,
wobei die koaxiale Hochfrequenzleitung (108) zumindest einen Innenleiter (110) und zumindest einen Außenleiter (112) zur Hochfrequenzabschirmung des zumindest einen Innenleiters (110) aufweist,
wobei der zumindest eine Außenleiter (112) den zumindest einen Innenleiter (110) umgibt,
wobei der zumindest eine Außenleiter (112) und der zumindest eine Innenleiter (110) voneinander isoliert sind.

13. Verfahren (200) nach dem vorangehenden Anspruch,
wobei bei dem Verbinden (208) der ersten Hochfrequenzkomponente (102) und der zweiten Hochfrequenzkomponente (104) über das Verdrahtungssubstrat (106) zumindest ein Hochfrequenzsignal-Anschluss (130) der ersten Hochfrequenzkomponente (102) über den zumindest einen Innenleiter (110) mit zumindest einem Hochfrequenzsignal-Anschluss (132) der zweiten Hochfrequenzkomponente (104) verbunden wird,
wobei bei dem Verbinden (208) der ersten Hochfrequenzkomponente (102) und der zweiten Hochfrequenzkomponente (104) über das Verdrahtungssubstrat (106) zumindest ein Hochfrequenzabschirm-Anschluss (134, 136) der ersten Hochfrequenzkomponente (102) über den zumindest einen Außenleiter (112) mit zumindest einem Hochfrequenzabschirm-Anschluss (138, 140) der zweiten Hochfrequenzkomponente (104) verbunden wird.

14. Verfahren (200) nach dem vorangehenden Anspruch,
wobei der zumindest eine Innenleiter (110) lateral in dem Verdrahtungssubstrat (106) verläuft, so dass der zumindest eine Innenleiter (110) parallel zu einer der ersten Hochfrequenzkomponente (102) und/oder der zweiten Hochfrequenzkomponente (104) benachbarten Oberfläche (142) des Verdrahtungssubstrats (106) angeordnet ist,
wobei der zumindest eine Innenleiter (110) über zumindest zwei voneinander beabstandete und vertikal in dem Verdrahtungssubstrat (106) verlaufende Verbindungsleiter (170) an die Oberfläche (142) des Verdrahtungssubstrats (106) geführt ist,
wobei bei dem Verbinden (208) der ersten Hochfrequenzkomponente (102) und der zweiten Hochfrequenzkomponente (104) über das Verdrahtungssubstrat (106) ein erster Verbindungsleiter der zumindest zwei Verbindungsleiter (170) mit dem zumindest einen Hochfrequenzsignal-Anschluss (130) der ersten Hochfrequenzkomponente (102) verbunden wird,
wobei bei dem Verbinden (208) der ersten Hochfrequenzkomponente (102) und der zweiten Hochfrequenzkomponente (104) über das Verdrahtungssubstrat (106) ein zweiter Verbindungsleiter der zumindest zwei Verbindungsleiter (170) mit dem zumindest einen Hochfrequenzsignal-Anschluss (132) der zweiten Hochfrequenzkomponente (104) verbunden wird.

15. Verfahren (200) nach einem der vorangehenden Ansprüche,
wobei das Bereitstellen (206) des Verdrahtungssubstrats (106) aufweist:
Bereitstellen eines Substrats,
Bilden der koaxialen Hochfrequenzleitung (108) in dem Substrat.
